(19)

Europäisches
Patentamt
European
Patent Office
Office européen
des brevets

(11) **EP 3 975 378 A1**

(12) **EUROPEAN PATENT APPLICATION**
published in accordance with Art. 153(4) EPC

(43) Date of publication:
**30.03.2022 Bulletin 2022/13**

(21) Application number: **20815377.5**

(22) Date of filing: **29.05.2020**

(51) International Patent Classification (IPC):
**H02J 7/00** (2006.01)       **H01M 10/44** (2006.01)

(52) Cooperative Patent Classification (CPC):
**Y02E 60/10**

(86) International application number:
**PCT/CN2020/093513**

(87) International publication number:
**WO 2020/239114 (03.12.2020 Gazette 2020/49)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **30.05.2019 CN 201910463953**

(71) Applicant: **GUANGDONG OPPO MOBILE
TELECOMMUNICATIONS
CORP., LTD.
Wusha, Chang'an
Dongguan
Guangdong 523860 (CN)**

(72) Inventors:
• **XIE, Hongbin
Dongguan, Guangdong 523860 (CN)**
• **ZHANG, Jun
Dongguan, Guangdong 523860 (CN)**

(74) Representative: **Taor, Simon Edward William et al
Venner Shipley LLP
200 Aldersgate
London EC1A 4HD (GB)**

(54) **CHARGING METHOD AND APPARATUS, CHARGING SYSTEM, ELECTRONIC DEVICE,
STORAGE MEDIUM**

(57)    A charging method and apparatus, a charging system, an electronic device, and a storage medium. The charging method comprises: establishing a charging current mapping relationship according to the correlation between charging information parameters and the open circuit voltage of a first electrode of a battery in a terminal device as well as the correlation between the charging information parameters and the impedance of the first electrode of the battery; during charging, obtaining the charging information parameters of the battery in the terminal device; determining a charging current according to the charging information parameters and the charging mapping relationship; and controlling the battery to be charged using the charging current. The present charging method can adjust the charging current according to the current state of the battery, so that the charging current is always maintained at the maximum allowable current of the battery so as to accelerate the charging speed of the battery, and in addition, the current during charging is not greater than the maximum allowable current to prevent battery aging and avoid side reactions due to excessive current, thereby improving the safety of battery charging.

Fig. 1

# Description

## CROSS REFERENCE

This application claims priority to Chinese Application No. 201910463953.4, filed on May 30, 2019. The entire disclosures of the above applications are incorporated herein by reference.

## FIELD OF THE DISCLOSURE

The present disclosure relates to a charging technology, and more particularly, to a charging method and device, a charging system, an electronic device and a storage medium.

## BACKGROUND

As the progress and development of the technology, the power consumption of the terminal devices, including smart phones, increases. However, the power density of the battery has come to its bottleneck. Therefore, it's important to raise the charging efficiency of the battery under limited power density.

Conventionally, the charging current is increased to raise the charging efficiency of the battery. However, using a high current to charge the battery for a long time may reduce the lifetime of the battery and the high current may have a safety issue.

Please note, the above illustration should be used to enhance the understanding of the background of the present disclosure. Therefore, it does not necessarily include any prior art information known by a person having ordinary skills in the art.

## SUMMARY

One objective of an embodiment of the present disclosure is to provide a charging method and device, a charging system, an electronic device and a storage medium to solve the above-mentioned issues.

According to an embodiment of the present disclosure, a charging method used in a terminal device is disclosed. The charging method comprises: establishing a charging current mapping relationship according to a relationship between a charging information parameter and an open circuit voltage of a first electrode of a battery of the terminal device and a relationship between the charging information parameter and an impedance of the first electrode of the battery; wherein the charging current mapping relationship comprises a mapping relationship between the charging information parameter and a maximum battery charging current; obtaining the charging information parameter of the battery during a charging operation; determining a charging current according to the charging information parameter and the charging current mapping relationship; and charging the battery by using the charging current.

According to an embodiment of the present disclosure, a charging device used in a terminal device is disclosed. The charging device comprises: an establishing module, configured to establish a charging current mapping relationship according to a relationship between a charging information parameter and an open circuit voltage of a first electrode of a battery of the terminal device and a relationship between the charging information parameter and an impedance of the first electrode of the battery; wherein the charging current mapping relationship comprises a mapping relationship between the charging information parameter and a maximum battery charging current; a first obtaining module, configured to obtain the charging information parameter of the battery during a charging operation; a first determining module, configured to determine a charging current according to the charging information parameter and the charging current mapping relationship; and a charging module, configured to charge the battery by using the charging current.

According to an embodiment of the present disclosure, a charging system used in a terminal device is disclosed. The charging system comprises: a checking circuit, configured to check a charging information parameter of a battery in the terminal device; and a controller, connected to the checking circuit, configured to receive the charging information parameter, load a charging mapping relationship according to the charging information parameter, determine a charging current through the charging mapping relationship, and charge the battery by utilizing the charging current.

According to an embodiment of the present disclosure, an electronic device is disclosed. The electronic device comprises: a storage device, configured to store computer readable instructions; and a processor, configured to execute the computer readable instructions to perform the above-mentioned charging method.

According to an embodiment of the present disclosure, a computer readable medium is disclosed. The computer readable medium stores computer readable programs for a processor to execute to perform the above-mentioned charging method.

It should be understood that the above general description and the following detailed description are only exemplary and explanatory, and cannot limit the present disclosure.

## BRIEF DESCRIPTION OF THE DRAWINGS

Some example embodiments of the present invention will be described below in detail with reference to the accompanying drawings.

Fig. 1 is a flow chart of a charging method according to a first embodiment of the present disclosure.
Fig. 2 is a flow chart of a charging method according to a second embodiment of the present disclosure.
Fig. 3 is a flow chart of a charging method according to a third embodiment of the present disclosure.

Fig. 4 is a flow chart of a charging method according to a fourth embodiment of the present disclosure.

Fig. 5 is a flow chart of a charging method according to a fifth embodiment of the present disclosure.

Fig. 6 is a flow chart of a charging method according to a sixth embodiment of the present disclosure.

Fig. 7 is a block diagram of a charging device according to a first embodiment of the present disclosure.

Fig. 8 is a block diagram of a charging device according to a second embodiment of the present disclosure.

Fig. 9 is a block diagram of a third obtaining module according to an embodiment of the present disclosure.

Fig. 10 is a block diagram of a charging device according to a third embodiment of the present disclosure.

Fig. 11 is a block diagram of a charging device according to a fourth embodiment of the present disclosure.

Fig. 12 is a block diagram of a charging device according to a fifth embodiment of the present disclosure.

Fig. 13 is a block diagram of a charging device according to a sixth embodiment of the present disclosure.

Fig. 14 is a block diagram of a charging system according to a first embodiment of the present disclosure.

Fig. 15 is a diagram of an electronic device according to a first embodiment of the present disclosure.

Fig. 16 is a diagram of a computer storage medium according to a first embodiment of the present disclosure.

DETAILED DESCRIPTION

The above and other aspects and features of the present invention will be described more fully hereinafter with reference to the accompanying drawings, in which example embodiments of the present inventions are shown. While some example embodiments of the present invention have been described using specific terms, such description is for illustrative purposes, and it is to be understood that changes and variances may be made without departing from the spirit or scope of the following claims. Further, it should be understood that parts, which are not essential to a complete understanding of the present invention, may be omitted in the drawings for clarity of description. Like reference numerals are used to identify like elements throughout different drawings.

It will be understood that, although the terms "first", "second", "third", etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section discussed below could be termed a second element, component, region, layer or section, without departing from the spirit and scope of the inventive concept.

The terminology used herein is for the purpose of describing particular embodiments and is not intended to be limiting of the inventive concept. As used herein, the singular forms "a" and "an" are intended to include the plural forms as well, unless the context clearly indicates otherwise. It will be further understood that the terms "includes," "including," "comprises" and/or "comprising," when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Expressions such as "at least one of," when preceding a list of elements, modify the entire list of elements and do not modify the individual elements of the list. Further, the use of "may" when describing embodiments of the inventive concept refers to "one or more embodiments of the inventive concept."

According to an embodiment, the present disclosure discloses a charging method, which could be used in a terminal device, such as a computer, a smart phone, a tablet, a vehicle computer, a wearable device, and/or a player.

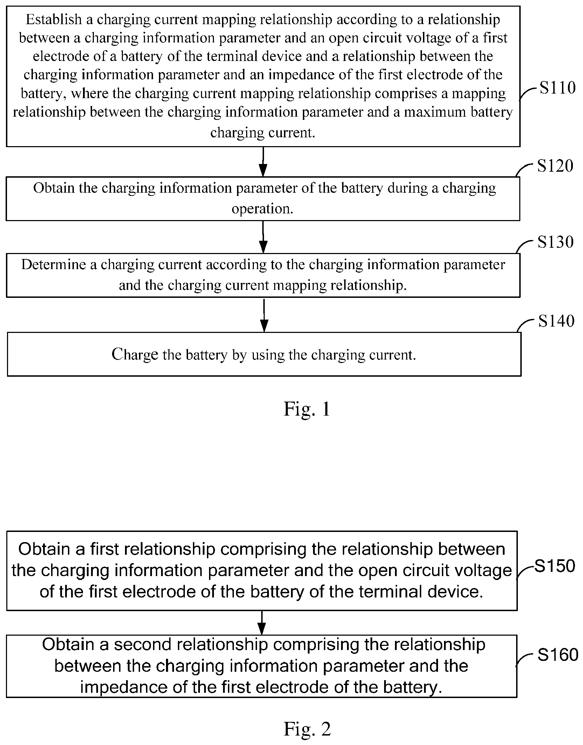

Please refer to Fig. 1. Fig. 1 is a flow chart of a charging method according to a first embodiment of the present disclosure. As shown in Fig. 1, the charging method comprises:

Block S110: Establish a charging current mapping relationship according to a relationship between a charging information parameter and an open circuit voltage of a first electrode of a battery of the terminal device and a relationship between the charging information parameter and an impedance of the first electrode of the battery. The charging current mapping relationship comprises a mapping relationship between the charging information parameter and a maximum battery charging current.

Block S120: Obtain the charging information parameter of the battery during a charging operation.

Block S130: Determine a charging current according to the charging information parameter and the charging current mapping relationship.

Block S140: Charge the battery by using the charging current.

In the charging method of this embodiment, during the charging operation, the maximum charging current could be determined according to the charging information parameter and the charging mapping relationship. In one aspect, the charging current could be adjusted according to the current condition of the battery such that the charging current could be a maximum available current to raise the charging speed of the battery. In another aspect, the charging current will not be over the maximum available current during the charging operation. This could increase the lifetime of the battery and could avoid the side effect caused by the high current, such as lithium precipitation. Thus, the safety for charging the battery could also be raised.

In one embodiment, the charging information parameter could comprise a battery power status and a battery temperature.

In the Block S110, a charging current mapping relationship is established according to a relationship between a charging information parameter and an open circuit voltage of a first electrode of a battery of the terminal device and a relationship between the charging information parameter and an impedance of the first electrode of the battery.

Here, the first electrode could be a positive electrode or a negative electrode of the battery. The relationship between the open circuit voltage of the first electrode of the battery and both the battery power status and the battery temperature could be labeled as Ue. Ue could be an equation of the open circuit voltage of the first electrode of the battery and both the battery power status and the battery temperature. Or Ue could be a table of the mapping relationship between the open circuit voltage of the first electrode of the battery and both the battery power status and the battery temperature.

The relationship between the impedance of the first electrode of the battery and both the battery power status and the battery temperature could be labeled as R. R could be an equation of the impedance of the first electrode of the battery and both the battery power status and the battery temperature. Or, Ue could be a table of the mapping relationship between the impedance of the first electrode of the battery and both the battery power status and the battery temperature. Through the following formula, the charging mapping relationship could be obtained:

$$In = Ue/R$$

In the Block S120, the battery power status and the battery temperature could be obtained. Here, the batter power status could be obtained by a power status detecting circuit. The battery temperature could be detected by the temperature sensor inside the terminal. The power status detecting circuit could be an existed circuit in the terminal or an independent circuit. The temperature sensor could be placed in the electrode of the battery, such as the positive electrode or the negative electrode. In the actual implementation, the temperature sensor could be placed in another location of the battery. In addition, one or more temperature sensors could be placed to detect the power temperature. When multiple temperature sensors are placed to detect the power temperature, the highest measured temperature could be regarded as the battery temperature or an average of the measured temperatures could be regarded as the battery temperature.

In the Block S130, the charging current could be determined according to the battery power status, the battery temperature and the charging current mapping relationship. The charging current mapping relationship comprises a mapping relationship between the charging current and both the battery power status and the battery temperature. The charging current mapping relationship is stored in the storage device of the terminal device. It could be stored in the storage device in the form of a table or a curve. In the charging operation, the charging current mapping relationship stored in the storage device could be loaded to determine the charging current.

In this embodiment, the charging current mapping relationship is a table stored in the storage device. In this case, the mapping relationship is discrete and comprises relationships between the charging currents and both multiple battery power statuses and power temperatures. In the actual detection, the detection points in the Block S120 might be different from the points stored in the charging current mapping relationship. In this case, the charging current of the point closest to the detection point could be taken as the current charging current. Or, the mapping relationship could be a curve stored in the storage device. That is, the mapping relationship could be a binary equation of a relationship between the charging current and both the battery power status and the battery temperature. When the current battery temperature and the current battery power status are detected, the current battery temperature and the current battery power status could be substituted into the equation to obtain the charging current.

In the Block S140, the charging current is used to charge the battery. That is, the charging current obtained in the Block S130 is used to charge the battery. Furthermore, a current adjusting circuit could be used to adjust the charging current. The current adjusting circuit adjusts the actual charging current to be consistent with the calculated charging current in response to the result of the Block S130.

In one embodiment, the charging information parameter could comprise a battery power status and a battery cycle number.

In the Block S110, a charging current mapping relationship is established according to a relationship between a charging information parameter and an open circuit voltage of a first electrode of a battery of the terminal device and a relationship between the charging information parameter and an impedance of the first electrode of the battery.

Here, the first electrode could be a positive electrode or a negative electrode of the battery. The relationship between the impedance of the first electrode of the battery and both the battery power status and the battery cycle number could be labeled as Ue. Ue could be an equation of the impedance of the first electrode of the battery and both the battery power status and the battery cycle number. Or, Ue could be a table of the mapping relationship between the impedance of the first electrode of the battery and both the battery power status and the battery cycle number.

The relationship between the impedance of the first electrode of the battery and both the battery power status and the battery cycle number could be labeled as R. R could be an equation of the impedance of the first electrode of the battery and both the battery power status and the battery cycle number. Or, Ue could be a table of the mapping relationship between the impedance of the first electrode of the battery and both the battery power status and the battery temperature. Through the following formula, the charging mapping relationship could be obtained:

$$In=Ue/R$$

In the Block S120, the battery power status and the battery cycle number could be obtained. Here, the batter power status could be obtained by a power status detecting circuit. The battery cycle number could be detected by a counter. Every time when the battery is charged or discharged, the counter adds 1. Specifically, a triggering switch could be placed at the charging port of the terminal device. The power status detecting circuit could be an existed circuit in the terminal or an independent circuit. The temperature sensor could be placed in the electrode of the battery, such as the positive electrode or the negative electrode. In the actual implementation, the temperature sensor could be placed in another location of the battery. In addition, one or more temperature sensors could be placed to detect the power temperature. When multiple temperature sensors are placed to detect the power temperature, the highest measured temperature could be regarded as the battery temperature or an average of the measured temperatures could be regarded as the battery temperature.

In the Block S130, the charging current could be determined according to the battery power status, the battery cycle number and the charging current mapping relationship. The charging current mapping relationship comprises a mapping relationship between the charging current and both the battery power status and the battery cycle number. The charging current mapping relationship is stored in the storage device of the terminal device. It could be stored in the storage device in the form of a table or a curve. In the charging operation, the charging current mapping relationship stored in the storage device could be loaded to determine the charging current.

In this embodiment, the charging current mapping relationship is a table stored in the storage device. In this case, the mapping relationship is discrete and comprises relationships between the charging currents and both multiple battery power statuses and battery cycle numbers. In the actual detection, the detection points in the Block S120 might be different from the points stored in the charging current mapping relationship. In this case, the charging current of the point closest to the detection point could be taken as the current charging current. Or, the mapping relationship could be a curve stored in the storage device. That is, the mapping relationship could be a binary equation of a relationship between the charging current and both the battery power status and the battery cycle number. When the current battery cycle number and the current battery power status are detected, the current battery cycle number and the current battery power status could be substituted into the equation to obtain the charging current.

In the Block S140, the charging current is used to charge the battery. That is, the charging current obtained in the Block S130 is used to charge the battery. Furthermore, a current adjusting circuit could be used to adjust the charging current. The current adjusting circuit adjusts the actual charging current to be consistent with the calculated charging current in response to the result of the Block S130.

In one embodiment, the charging information parameter could comprise a battery power status, a battery temperature and a battery cycle number.

In the Block S110, a charging current mapping relationship is established according to a relationship between a charging information parameter and an open circuit voltage of a first electrode of a battery of the terminal device and a relationship between the charging information parameter and an impedance of the first electrode of the battery.

The relationship between the impedance of the first electrode of the battery and all the battery power status, the battery temperature, and the battery cycle number could be labeled as Ue. Ue could be an equation of the impedance of the first electrode of the battery and all the battery power status, the battery temperature, and the battery cycle number. Or Ue could be a table of the mapping relationship between the impedance of the first electrode of the battery and all the battery power status, the battery temperature, and the battery cycle number.

The relationship between the impedance of the first electrode of the battery and all the battery power status, the battery temperature, and the battery cycle number could be labeled as R. R could be an equation of the impedance of the first electrode of the battery and all the battery power status, the battery temperature, and the battery cycle number. Or, Ue could be a table of the mapping relationship between the impedance of the first electrode of the battery and Ue. Through the following formula, the charging mapping relationship could be obtained:

$$In=Ue/R$$

In the Block S120, the battery power status, the battery temperature and the battery cycle number could be obtained. Here, the batter power status could be obtained by a power status detecting circuit. The battery temperature could be detected by a temperature sensor in the terminal device. The battery cycle number could be detected by a counter in the terminal device.

In the Block S130, the charging current could be determined according to the battery power status, the battery temperature, the battery cycle number and the charging current mapping relationship. The charging current mapping relationship comprises a mapping relationship between the charging current and all the battery power status, the battery temperature and the battery cycle number. The charging current mapping relationship is stored in the storage device of the terminal device. It could be stored in the storage device in the form of a table or a curve. In the charging operation, the charging current mapping relationship stored in the storage device could be loaded to determine the charging current.

In this embodiment, the charging current mapping relationship is a table stored in the storage device. In this case, the mapping relationship is discrete and comprises relationships between the charging currents and both multiple battery power statuses and battery cycle numbers. In the actual detection, the detection points in the Block S120 might be different from the points stored in the charging current mapping relationship. In this case, the charging current of the point closest to the detection point could be taken as the current charging current. Or, the mapping relationship could be a curve stored in the storage device. That is, the mapping relationship could be a binary equation of a relationship between the charging current and all the battery power status, the battery temperature and the battery cycle number. When the battery power status, the battery temperature and the battery cycle number are detected, the battery power status, the battery temperature and the battery cycle number could be substituted into the equation to obtain the charging current.

In the Block S140, the charging current is used to charge the battery. That is, the charging current obtained in the Block S130 is used to charge the battery. Furthermore, a current adjusting circuit could be used to adjust the charging current. The current adjusting circuit adjusts the actual charging current to be consistent with the calculated charging current in response to the result of the Block S130.

Please refer to Fig. 2. Fig. 2 is a flow chart of a charging method according to a second embodiment of the present disclosure. As shown in Fig. 2, the charging method could comprise following steps before the Block S110:

Block S150: Obtain a first relationship comprising the relationship between the charging information parameter and the open circuit voltage of the first electrode of the battery of the terminal device.

Block S160: Obtain a second relationship comprising the relationship between the charging information parameter and the impedance of the first electrode of the battery.

In the Block S150, the first relationship could be obtained. The first relationship comprises the relationship between the charging information parameter and the open circuit voltage of the first electrode of the battery of the terminal device. Here, a relationship between the open circuit voltage of the first electrode of the battery of the terminal device and at least one of the battery power status, the battery temperature, and the battery cycle number is obtained

In one embodiment, when the charging information parameter comprises the battery power status and the battery temperature, the Block S150 could comprise: obtaining the relationship between the open circuit voltage of the first electrode of the battery and both the battery power status and the battery temperature.

Here, the first electrode could be the positive electrode or the negative electrode of the battery. Here, the negative electrode of the battery is taken as the first electrode as an example. The three electrodes could be used to detect the open circuit voltage of the negative electrode of the battery. During the charging operation, the open circuit voltage of the negative electrode of the battery could be obtained according to the voltage difference between the voltage level of the negative electrode of the battery and the voltage levels of the three electrodes. The voltage level Li/Li+ could be taken as the voltage level 0. For example, during the charging operation, the battery testing device could be used to detect the open circuit voltage of the negative electrode. Under different battery temperatures, the curve of the battery power status and the open circuit voltage is detected to obtain the equation Ue of the open circuit voltage of the negative electrode related to the battery temperature and the battery power status.

In one embodiment, when the charging information parameter comprises the battery power status and the power cycle number, the Block S150 could comprise: obtaining the relationship between the open circuit voltage of the first electrode of the battery and both the battery power status and the battery cycle number. The three electrodes could be used to detect the curve of the battery power status and the open circuit voltage in different cycle numbers such that the equation Ue of the open circuit voltage of the negative electrode related to the battery power status and the battery cycle number could be obtained.

In one embodiment, when the charging information parameter comprises the battery power status, the battery temperature and the power cycle number, the Block S150 could comprise: obtaining the relationship between the open circuit voltage of the first electrode of the battery and both the battery power status and the battery cycle number. The three electrodes could be used to detect the curve of the battery power status and the open circuit voltage in different cycle numbers such that the equation Ue of the open circuit voltage of the negative electrode related to the battery power status and the battery cycle number could be obtained.

In the Block S160, the second relationship could be obtained. The second relationship comprises the relationship between the charging information parameter and the impedance of the first electrode of the battery.

In one embodiment, when the charging information parameter comprises the battery power status and the power temperature, the Block S160 could comprise: obtaining the relationship between the impedance of the first electrode of the battery and both the battery power status and the battery temperature. Under a predetermined battery power status and a predetermined battery temperature, the battery is charged or discharged by the first current to obtain the first voltage level of the first electrode. Here, the predetermined battery power status could be any battery power status and the predetermined battery temperature could be any battery temperature. Under the predetermined battery power status and the predetermined battery temperature, the battery is charged or discharged by the second current to obtain the second voltage level of the first electrode. The impedance of the first electrode could be determined according to the first current, the first voltage level, the second current and the second voltage level.

Here, the negative electrode is taken as the first electrode as an example. Under the predetermined battery power status and the predetermined battery temperature, the battery is charged by the first current I1 to obtain the first voltage level U1 of the negative electrode. Under the predetermined battery power status and the predetermined battery temperature, the battery is charged by the second current I2 to obtain the first voltage level U2 of the negative electrode. The impedance Rn of the negative electrode could be calculated:

$$Rn=(U1-U2)/(I1-I2)$$

Through adjusting the predetermined battery power status and the predetermined battery temperature, multiple predetermined battery power statuses and multiple predetermined battery temperatures, and corresponding impedances of the negative electrode of the battery could be obtained. That is, the equation of the impedance and both the battery temperature and the battery power status could be obtained. Furthermore, the equation R of the impedance and both the battery temperature and the battery power status could be obtained through simulations, such as interpolations.

In one embodiment, when the charging information parameter comprises the battery power status, the battery temperature and the power cycle number, the Block S150 could comprise: obtaining the relationship between the open circuit voltage of the first electrode of the battery and both the battery power status and the battery cycle number. The three electrodes could be used to detect the curve of the battery power status and the open circuit voltage in different cycle numbers such that the equation Ue of the open circuit voltage of the negative electrode related to the battery power status and the battery cycle number could be obtained.

In the Block S160, the second relationship could be obtained. The second relationship comprises the relationship between the charging information parameter and the impedance of the first electrode of the battery.

In one embodiment, when the charging information parameter comprises the battery power status and the battery cycle number, the Block S160 could comprise: obtaining the relationship between the impedance of the first electrode of the battery and both the battery power status and the battery cycle number. Under a predetermined battery power status and a predetermined battery cycle number, the battery is charged or discharged by the first current to obtain the first voltage level of the first electrode. Here, the predetermined battery power status could be any battery power status and the battery cycle number could be any battery cycle number. Under the predetermined battery power status and the predetermined battery cycle number, the battery is charged or discharged by the second current to obtain the second voltage level of the first electrode. The impedance of the first electrode could be determined according to the first current, the first voltage level, the second current and the second voltage level.

Here, the negative electrode is taken as the first electrode as an example. Under the predetermined battery power status and the predetermined battery cycle number, the battery is charged by the first current I1 to obtain the first voltage level U1 of the negative electrode. Under the predetermined battery power status and the predetermined battery cycle number, the battery is charged by the second current I2 to obtain the first voltage level U2 of the negative electrode. The impedance Rn of the negative electrode could be calculated:

$$Rn=(U1-U2)/(I1-I2)$$

Through adjusting the predetermined battery power status and the predetermined battery cycle number, multiple predetermined battery power statuses and multiple predetermined battery cycle numbers, and corresponding impedances of the negative electrode of the battery could be obtained. That is, the equation of the impedance and both the battery cycle number and the battery power status could be obtained. Furthermore, the equation R of the impedance and both the battery cycle number and the battery power status could be obtained through simulations, such as interpolations.

In one embodiment, the charging information parameter comprises the battery power status, the battery temperature and the battery cycle number, the Block S160 could comprise: obtaining the relationship between the impedance of the first electrode of the battery and all the battery power status, the battery temperature and the battery cycle number. Under a predetermined battery power status, a predetermined battery temperature and a predetermined battery cycle number, the battery is charged or discharged by the first current to obtain the first voltage level of the first electrode. Here, the predetermined battery power status could be any battery power status, the predetermined battery temperature could be any battery temperature and the battery cycle number could be any battery cycle number. Under the predetermined battery power status, the predetermined battery temperature and the predetermined battery cycle number, the battery is charged or discharged by the second current to obtain the second voltage level of the first electrode. The impedance of the first electrode could be determined according to the first current, the first voltage level, the second current and the second voltage level.

Under the predetermined battery power status, the predetermined battery temperature and the predetermined battery cycle number, the battery is charged by the first current I1 to obtain the first voltage level U1 of the negative electrode. Under the predetermined battery power status, the predetermined battery temperature and the predetermined battery cycle number, the battery is charged by the second current I2 to obtain the first voltage level U2 of the negative electrode. The impedance Rn of the negative electrode could be calculated:

$$Rn=(U1-U2)/(I1-I2)$$

Through adjusting the predetermined battery power status, the predetermined battery temperature and the predetermined battery cycle number, multiple predetermined battery power statuses, multiple battery temperatures and multiple predetermined battery cycle numbers, and corresponding impedances of the negative electrode of the battery could be obtained. That is, the equation of the impedance and all the battery cycle number, the battery temperature and the battery power status could be obtained. Furthermore, the equation R of the impedance and all the battery cycle number, the battery temperature and the battery power status could be obtained through simulations, such as interpolations.

In the actual implementation, the first relationship and the second relationship could be discrete points. For example, the first relationship could be a table of the battery power status, the battery temperature, the battery cycle number and the open circuit voltage of the first electrode. The second relationship could be a table of the battery power status, the battery temperature, the battery cycle number and the impedance of the first electrode. For example, the charging current mapping relationship could be a table of the battery power status, the battery temperature, the battery cycle number and the charging current. However, this is only an example, not a limitation of the present disclosure.

Through the first relationship and the second relationship, the maximum charging current corresponding to the battery charging information parameter could be obtained. The maximum charging current is the maximum available current for safely charging the battery under the current charging information parameter.

The first current and the second current could be any currents but have different current values.

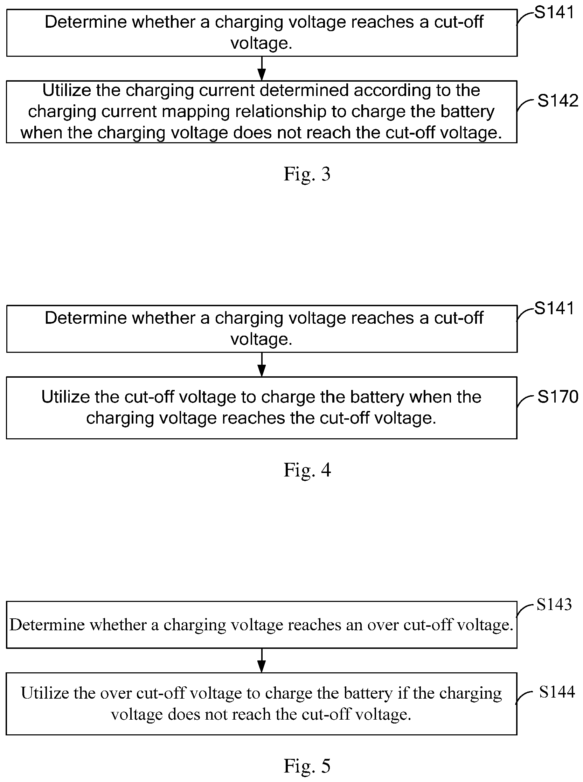

Please refer to Fig. 3. Fig. 3 is a flow chart of a charging method according to a third embodiment of the present disclosure. As shown in Fig. 3, the Block S140 comprises:

Block S141: Determine whether a charging voltage reaches a cut-off voltage.
Block S142: Utilize the charging current determined according to the charging current mapping relationship to charge the battery when the charging voltage does not reach the cut-off voltage.

In the Block S141, whether a charging voltage reaches a cut-off voltage is determined. During the charging operation, the current voltage of the battery is real-time checked. If the current charging voltage does not reach the cut-off voltage, then the charging voltage does not reach the cut-off voltage. If the current charging voltage is higher or equal to the cut-off voltage, then the charging voltage reaches the cut-off voltage. A voltage detecting circuit placed in the terminal device could be used to detect the current charging voltage. For a specific battery, the cut-off voltage could be a fixed value. For example, for a lithium-ion battery, the cut-off voltage could be 4.2V. This threshold value could be stored in the storage device of the terminal device.

In the Block S142, if the charging voltage does not reach the cut-off voltage, then the charging current determined according to the charging current mapping relationship is used to charge the battery. When the current charging voltage is lower than the cut-off voltage, the charging current determined according to the Block S130 is used to charge the battery. During the charging operation, because the charging voltage increases from low to high. Therefore, in the initial stage of the charging operation, the charging voltage is not higher than the cut-off voltage. In this way, it is possible to start determining whether the current charging voltage reaches the cut-off voltage after a specific period of time after the charging operation begins. For example, after charging for 20 minutes, the current charging voltage is detected to determine whether the current charging voltage reaches the cut-off voltage. In the actual implementation, the battery may still have a remaining power before the charging operation, the battery power status could be used to start determining whether the charging voltage reaches the cut-off voltage. For example, after the battery power reaches 80%, it starts to determine whether the current charging voltage reaches the cut-off voltage.

Please refer to Fig. 4. Fig. 4 is a flow chart of a charging method according to a fourth embodiment of the present disclosure. As shown in Fig. 4, the charging method further comprises a following step after the Block S141.

Block S170: Utilize the cut-off voltage to charge the battery when the charging voltage reaches the cut-off voltage.

In the Block S170, if the charging voltage reaches the cut-off voltage, then the constant cut-off voltage could be used to charge the battery. When the charging voltage reaches the cut-off voltage, in order to avoid the charging voltage being too high to damage the battery (such as lithium precipitation or high temperature), the battery goes into a constant voltage charging stage. In this stage, the cut-off voltage is used to charge the battery. At this time, the charging current gradually decreases. When the charging current is reduced to the cut-off current, the battery is completely charged and the charging operation ends. Here, the cut-off current is a current value where the battery is no longer charged. When the charging current is reduced to the cut-off current in the constant voltage charging stage, the charging speed quickly reduces and the battery power is near to saturation and thus could be regarded as being full.

Please refer to Fig. 5. Fig. 5 is a flow chart of a charging method according to a fifth embodiment of the present disclosure. As shown in Fig. 5, the Block S140 further comprises:

> Block S143: Determine whether a charging voltage reaches an over cut-off voltage.
> Block S144: Utilize the charging current determined according to the charging current mapping relationship to charge the battery if the charging voltage does not reach the over cut-off voltage.

In the Block S143, whether a charging voltage reaches an over cut-off voltage could be determined. The over cut-off voltage is higher than the cut-off voltage. During the charging operation, the current voltage of the battery is real-time checked and compared with the over cut-off voltage. If the current charging voltage does not reach the over cut-off voltage, then the charging voltage does not reach the over cut-off voltage. If the current charging voltage is higher or equal to the over cut-off voltage, then the charging voltage reaches the over cut-off voltage. A voltage detecting circuit placed in the terminal device could be used to detect the current charging voltage. For a specific battery, the cut-off voltage could be a fixed value. For example, for a lithium-ion battery, the cut-off voltage could be 4.2V. The over cut-off could be a voltage value by adding a specific value to the cut-off voltage, such as 4.2V+0.5V. In the actual implementation, the over cut-off voltage could be selected according to the model type of the battery.

When the charging voltage of the lithium-ion battery reaches the cut-off voltage, the charging voltage could be appropriately raised to expedite the charging operation without largely affecting the lifetime and safety of the battery.

In the Block S144, if the charging voltage does not reach the over cut-off voltage, then the charging current determined according to the charging current mapping relationship could be used to charge the battery. Accordingly, when the current charging voltage is lower than the over cut-off voltage, the charging current determined in the Block S130 could be used to charge the battery.

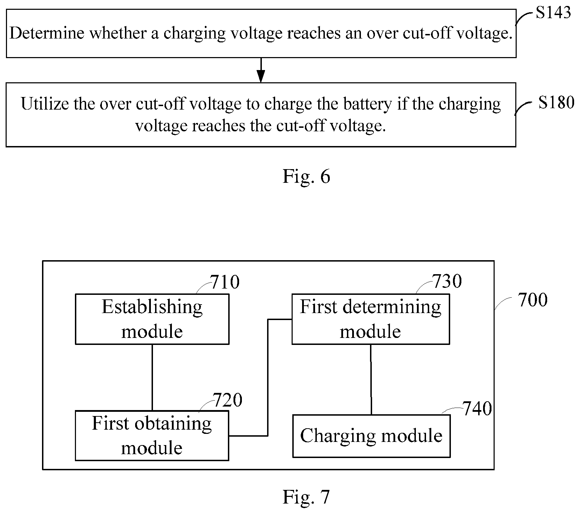

Please refer to Fig. 6. Fig. 6 is a flow chart of a charging method according to a sixth embodiment of the present disclosure. As shown in Fig. 6, the charging method further comprises the following step after the Block S143:

Block S180: Utilize the over cut-off voltage to charge the battery if the charging voltage reaches the cut-off voltage.

In the Block S180, if the charging voltage reaches the over cut-off voltage, then the constant over cut-off voltage could be used to charge the battery. When the charging voltage reaches the over cut-off voltage, in order to avoid the charging voltage being too high to damage the battery (such as lithium precipitation or high temperature), the battery goes into a constant voltage charging stage. In this stage, the over cut-off voltage is used to charge the battery. At this time, the charging current gradually decreases. When the charging current is reduced to the cut-off current, the battery is completely charged and the charging operation ends. Here, the cut-off current is a current value where the battery is no longer charged. When the charging current is reduced to the cut-off current in the constant voltage charging stage, the charging speed quickly reduces and the battery power is near to saturation and thus could be regarded as being full.

In this embodiment, the cut-off current becomes higher as the battery age increases. Therefore, during the charging operation, the cut-off current corresponding to the battery age could be used to determine whether to stop charging. In the actual implementation, the cut-off current could be a fixed value. These changes all fall within the scope of the present disclosure.

The charging method according to an embodiment determines the charging current according to the charging information parameter and the charging current mapping relationship. In one aspect, the charging current could be adjusted according to the current condition of the battery such that the charging current could be a maximum available current to raise the charging speed of the battery. In another aspect, the charging current will not be over the maximum available current during the charging operation. This could increase the lifetime of the battery and could avoid the side effect caused by the high current, such as lithium precipitation. Thus, the safety for charging the battery could also be raised.

Please refer to Fig. 7. Fig. 7 is a block diagram of a charging device according to a first embodiment of the present disclosure. As shown in Fig. 7, the charging device 700 is disclosed. The charging device 700 comprises an establishing module 710, a first obtaining module 720, a first determining module 730, and a charging module 740.

The establishing module 710 is configured to establish a charging current mapping relationship according to a relationship between a charging information parameter and an open circuit voltage of a first electrode of a battery of the terminal device and a relationship between the charging information parameter and an impedance of the first electrode of the battery. The charging current mapping relationship comprises a mapping relationship between the charging information parameter and a maximum battery charging current.

The first obtaining module 720 is configured to obtain the charging information parameter of the battery during a charging operation.

The first determining module 730 is configured to determine a charging current according to the charging information parameter and the charging current mapping relationship.

The charging module 740 is configured to charge the battery by using the charging current.

The establishing module 710 could be an establishing sub-circuit for establishing a mapping relationship. The first obtaining module 720 could be a battery charging status detecting circuit (such as a current detecting circuit, a voltage detecting circuit, a temperature sensor and a power status checking circuit). The charging module 740 could be a charging management circuit.

The charging device according to an embodiment determines the charging current according to the charging information parameter and the charging current mapping relationship. In one aspect, the charging current could be adjusted according to the current condition of the battery such that the charging current could be a maximum available current to raise the charging speed of the battery. In another aspect, the charging current will not be over the maximum available current during the charging operation. This could increase the lifetime of the battery and could avoid the side effect caused by the high current, such as lithium precipitation. Thus, the safety for charging the battery could also be raised.

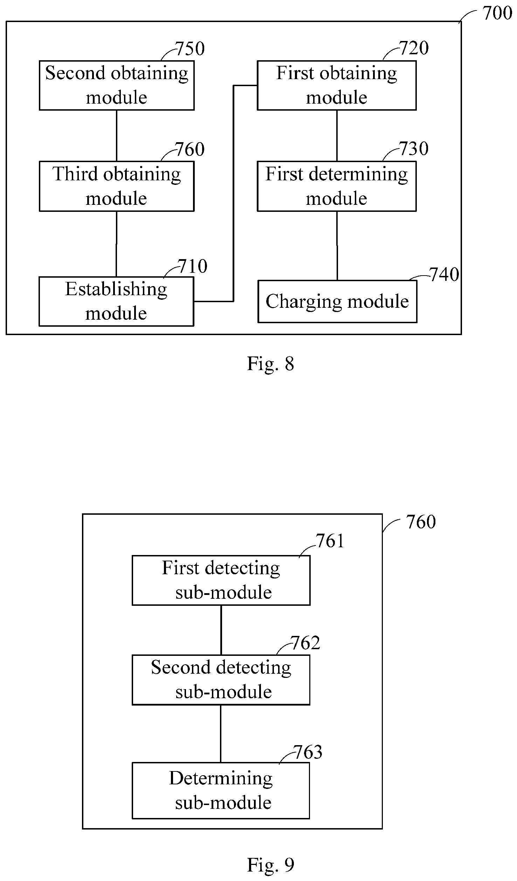

Please refer to Fig. 8. Fig. 8 is a block diagram of a charging device according to a second embodiment of the present disclosure. As shown in Fig. 8, the charging device 700 further comprises: a second obtaining module 750 and a third obtaining module 760.

The second obtaining module 750 is configured to obtain a first relationship, comprising the relationship between the charging information parameter and the open circuit voltage of the first electrode of the battery of the terminal device.

The third obtaining module 760 is configured to obtain a second relationship, comprising the relationship between the charging information parameter and the impedance of the first electrode of the battery.

When the charging information parameter comprises the battery power status, the battery temperature and the battery cycle number. The second obtaining module is configured to obtain the mapping relationship between the open circuit voltage of the first electrode of the battery and all the battery power status, the battery temperature and battery cycle number.

The third obtaining module is configured to obtain the mapping relationship between the impedance of the first electrode of the battery and all the battery power status, the battery temperature and battery cycle number.

The second obtaining module 750 could be a battery charging detecting circuit (such as a current detecting circuit, a voltage detecting circuit, a temperature sensor and a power status checking circuit). The third obtaining module 760 could be a battery charging detecting circuit (such as a current detecting circuit, a voltage detecting circuit, a temperature sensor and a power status checking circuit).

Please refer to Fig. 9. Fig. 9 is a block diagram of a third obtaining module according to an embodiment of the present disclosure. As shown in Fig. 9, the third obtaining module 760 comprises a first detecting sub-module 761, a second detecting sub-module 762, and a determining sub-module 763.

The first detecting sub-module 761 is configured to utilize a first current to charge or discharge the battery under a predetermined battery power status, a predetermined battery temperature, and a predetermined battery cycle to obtain a first voltage level of the first electrode.

The second detecting sub-module 762 is configured to utilize a second current to charge or discharge the battery under the predetermined battery power status, the predetermined battery temperature, and the predetermined battery cycle to obtain a second voltage level of the first electrode.

The determining sub-module 763 is configured to determine the impedance of the first electrode according to the first current, the first voltage level, the second current and the second voltage level.

The first detecting sub-module 761 could be a voltage level detecting circuit. The second detecting sub-module 762 could be a voltage level detecting circuit.

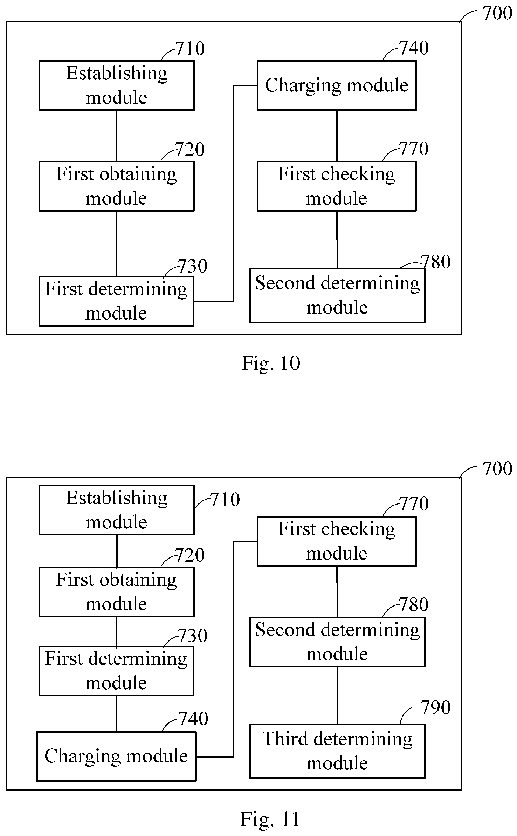

Please refer to Fig. 10. Fig. 10 is a block diagram of a charging device according to a third embodiment of the present disclosure. As shown in Fig. 10, the charging device further comprises: a first checking module 770 and a second determining module 780.

The first checking module 770 is configured to check whether a charging voltage reaches a cut-off voltage.

The second determining module 780 is configured to utilize the charging current determined according to the charging current mapping relationship to charge the battery if the charging voltage does not reach the cut-off voltage.

The first checking module could be a determining circuit in a processor. The second determining module 780 could be a determining circuit in a processor.

Please refer to Fig. 11. Fig. 11 is a block diagram of a charging device according to a fourth embodiment of the present disclosure. As shown in Fig. 11, the charging device further comprises: a third determining module 790.

The third determining module 790 is configured to utilize the cut-off voltage to charge the battery if the charging voltage reaches the cut-off voltage.

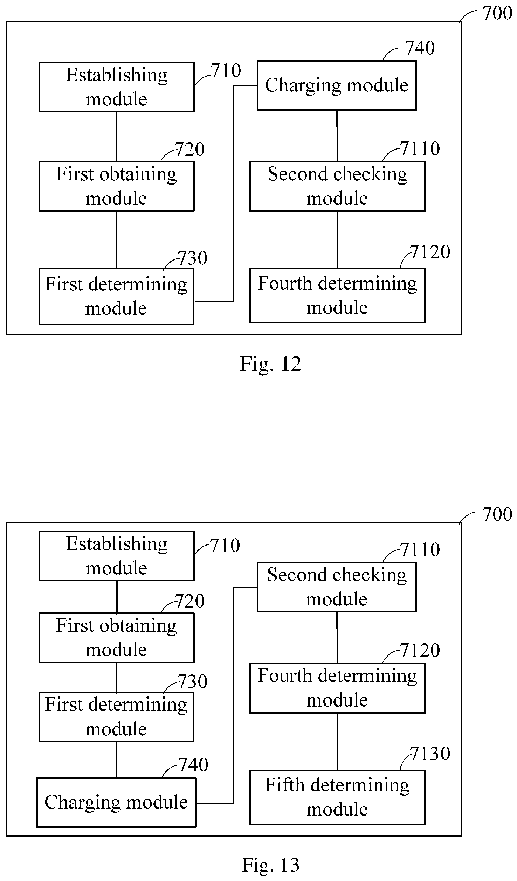

Please refer to Fig. 12. Fig. 12 is a block diagram of a charging device according to a fifth embodiment of the present disclosure. As shown in Fig. 12, the charging device further comprises: a second checking module 7110 and a fourth determining module 7120.

The second checking module 7110 is configured to check whether a charging voltage reaches an over cut-off voltage. The over cut-off voltage is higher than a cut-off voltage.

The fourth determining module 7120 is configured to utilize the charging current determined according to the charging current mapping relationship to charge the battery if the charging voltage does not reach the over cut-off voltage.

The second checking module 7110 could be a determining circuit in a processor. The fourth determining module 7120 could be a determining circuit in a processor.

Please refer to Fig. 13. Fig. 13 is a block diagram of a charging device according to a sixth embodiment of the present disclosure. The charging device further comprises a fifth determining module 7130. The fifth determining module 7130 is configured to utilize the over cut-off voltage to charge the battery if the charging voltage reaches the cut-off voltage. Here, the fifth determining module 7130 could be a determining circuit in a processor.

The charging device according to an embodiment determines the charging current according to the charging information parameter and the charging current mapping relationship. In one aspect, the charging current could be adjusted according to the current condition of the battery such that the charging current could be a maximum available current to raise the charging speed of the battery. In another aspect, the charging current will not be over the maximum available current during the charging operation. This could increase the lifetime of the battery and could avoid the side effect caused by the high current, such as lithium precipitation. Thus, the safety for charging the battery could also be raised.

Since the corresponding charging method has been illustrated in the above disclosure, further illustrations for the functions and operations of the modules in the charging device are omitted here.

In addition, although there are modules or sub-modules in the above charging device, this arrangement is not a limitation of the present disclosure. In the actual implementation, two or more modules/sub-modules could be integrated in one module/sub-module. Or, one module/sub-module could be further divided and implemented by more modules/sub-modules.

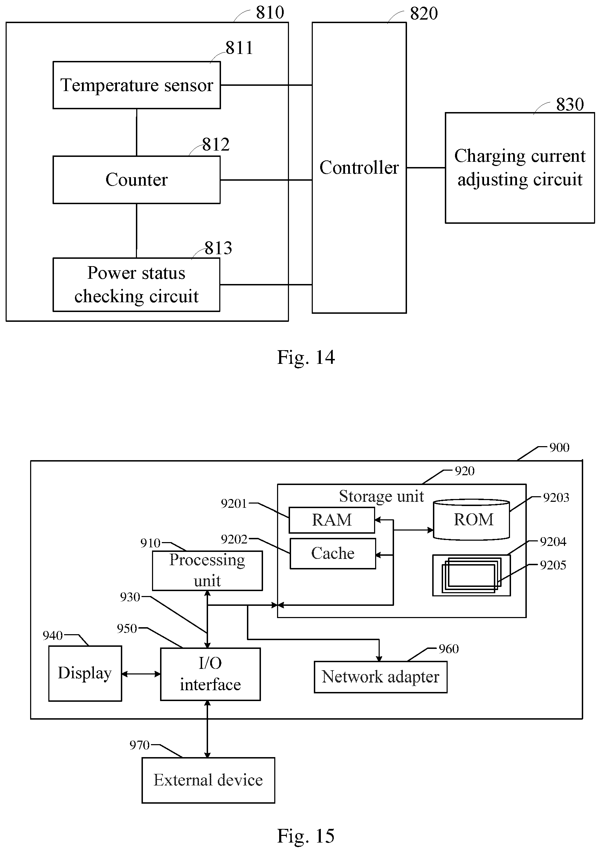

According to an embodiment of the present disclosure, a charging system used in the terminal device is disclosed. Please refer to Fig. 14. Fig. 14 is a block diagram of a charging system according to a first embodiment of the present disclosure. The charging system comprises a checking circuit 810 and a controller 820. The checking circuit 810 is configured to check a charging information parameter of a battery in the terminal device. The controller 820 is connected to the checking circuit and is configured to receive the charging information parameter, load a charging mapping relationship according to the charging information parameter, determine a charging current through the charging mapping relationship, and charge the battery by utilizing the charging current.

When the charging information parameter comprises a battery power status, a battery temperature and a battery cycle number, the checking circuit comprises a temperature sensor 811, a counter 812 and a power status checking circuit 813. The temperature sensor 811 is connected to the controller 820 and is configured to the battery temperature. The counter 812 is connected to the controller 820 and is configured to record the battery cycle number. The power status detecting circuit 813 is connected to the controller 820 and is configured to detect the battery power status.

The charging system could further comprise a charging current adjusting circuit 830. The charging current adjusting circuit 830 is connected to the controller 820 and is configured to provide a charging current to the battery in response to the control signal of the controller. The charging current is determined through the charging current mapping relationship.

The charging system could be placed in a terminal device or in a charging equipment inside the terminal device, partially placed in a terminal device or partially placed in a charging equipment inside the terminal device. These changes all fall within the scope of the present disclosure.

The charging system according to an embodiment determines the charging current according to the charging information parameter and the charging current mapping relationship. In one aspect, the charging current could be adjusted according to the current condition of the battery such that the charging current could be a maximum available current to raise the charging speed of the battery. In another aspect, the charging current will not be over the maximum available current during the charging operation. This could increase the lifetime of the battery and could avoid the side effect caused by the high current, such as lithium precipitation. Thus, the safety for charging the battery could also be raised.

According to an embodiment of the present disclosure, an electronic device is disclosed. Please refer to Fig. 15. Fig. 15 is a diagram of an electronic device 900 according to a first embodiment of the present disclosure. The electronic device 900 shown in Fig. 15 is only an example, not a limitation of the present disclosure.

As shown in Fig. 15, the electronic device 900 could be in a form of a computer. The electronic device 900 could comprise, but not limited to, at least one processing unit 910, at least one storage unit 920, a bus 930 connected to different system components (such as the processing unit 910 and the storage unit 920), and a display 940.

Here, the storage unit 920 stores program codes. These program codes could be executed by the processing unit 910 to perform any of the charging methods disclosed in the above embodiments.

The storage unit 920 may include a non-transitory computer-readable medium, such as a random access memory (RAM) 9201 and/or a cache memory 9202, and a read-only memory (ROM) 9203.

The storage unit 920 may also include a program/utility tool 9204 having a set of (at least one) program module 9205. Such program module 9205 includes but is not limited to: an operating system, one or more application programs, other program modules, and program data. Each of these examples or some combination may include the implementation of a network environment.

The bus 930 may represent one or more of several types of bus structures, including a storage unit bus or a storage unit controller, a peripheral bus, a graphics acceleration interface, a processing unit, or a local area using any bus structure among multiple bus structures bus.

The electronic device 900 may also communicate with one or more external devices 970 (such as keyboards, pointing devices, and Bluetooth devices), and may also communicate with one or more devices that enable a user to interact with the electronic device 900, and/or communicate with any device (e.g., router, modem, etc.) that enables the electronic device 900 to communicate with one or more other computing devices. This communication can be performed through an input/output (I/O) interface 950. In addition, the electronic device 900 may also communicate with one or more networks (for example, a local area network (LAN), a wide area network (WAN), and/or a public network, such as the Internet) through the network adapter 960. As shown in the figure, the network adapter 940 communicates with other modules of the electronic device 900 through the bus 930. It should be understood that although not shown in the figure, other hardware and/or software modules can be used in conjunction with the electronic device 900, including but not limited to: microcode, device drivers, redundant processing units, external disk drive arrays, RAID systems, tape drivers and data backup storage system, etc.

Through the description of the above embodiments, those skilled in the art can easily understand that the exemplary embodiments described herein can be implemented by software, or can be implemented by combining software with necessary hardware. Therefore, the technical solution according to the embodiments of the present disclosure can be realized in the form of a software product stored in a non-volatile storage medium (which can be a CD-ROM, USB disk, mobile hard disk, etc.) or on the network. The software product includes several instructions to make a computing device (which can be a personal computer, a server, a terminal device, or a network device, etc.) execute the method according to the embodiments of the present disclosure.

In the exemplary embodiment of the present disclosure, there is also provided a non-transitory computer-readable storage medium on which is stored a program product capable of implementing the above-mentioned method in this specification. In some embodiments, various aspects of the present invention may also be implemented in the form of a program product, which includes program code. When the program product runs on a terminal device, the program code is executable to enable the terminal device to perform the steps of the charging method according to various exemplary embodiments of the present disclosure.

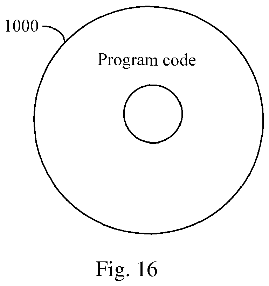

Referring to FIG. 16, a program product 1000 for implementing the above method according to an embodiment of the present invention is described. It can adopt a portable compact disk read-only memory (CD-ROM) and include program code, and can be installed in a terminal device. For example, running on a personal computer. However, the program product of the present invention is not limited to this. In this document, the readable storage medium can be any tangible medium that contains or stores a program, and the program can be used by or combined with an instruction execution system, device, or device.

The program product can use any combination of one or more computer-readable media. The computer-readable medium may be a non-transitory computer-readable signal medium or a non-transitory computer-readable storage medium. The non-transitory computer-readable storage medium may be. For example, but not limited to, an electrical, magnetic, optical, electromagnetic, infrared, or semiconductor system, or device, or a combination of any of the above. The non-transitory computer-readable storage media include: portable disks, hard disks, random access memory (RAM), read-only memory (ROM), erasable Type programmable read only memory (EPROM or flash memory), optical fiber, portable compact disk read only memory (CD-ROM), optical storage device, magnetic storage device, or any suitable combination of the above in electrical connections with one or more wires.

The computer-readable signal medium may include a data signal propagated in baseband or as a part of a carrier wave, and readable program code is carried therein. This propagated data signal can take many forms, including but not limited to electromagnetic signals, optical signals, or any suitable combination of the foregoing. The readable signal medium may also be any readable medium other than a readable storage medium, and the readable medium may send, propagate, or transmit a program for use by or in combination with the instruction execution system, apparatus, or device.

The program code contained on the readable medium can be transmitted by any suitable medium, including but not limited to wireless, wired, optical cable, RF, or any suitable combination of the foregoing.

The program code used to perform the operations of the present disclosure can be coded in any combination of one or more programming languages. The programming languages include object-oriented programming languages-such as Java, C++, etc., as well as conventional procedural programming languages. Programming language-such as "C" language or similar programming language. The program code can be executed entirely on the user's computing device, partly on the user's device, executed as an independent software package, partly on the user's computing device and partly executed on the remote computing device, or entirely on the remote computing device or server Executed on. In the case of a remote computing device, the remote computing device can be connected to a user computing device through any kind of network, including a local area network (LAN) or a wide area network (WAN), or it can be connected to an external computing device via the Internet provided by Internet service providers.

In addition, the above-mentioned drawings are merely schematic illustrations of the processing included in the method according to the exemplary embodiment of the present invention, and are not intended for limitation. It is easy to understand that the processing shown in the above drawings does not indicate or limit the time sequence of these processing. In addition, it is easy to understand that these processes can be executed synchronously or asynchronously in multiple modules. For example.

Any process or method described in the flowchart or otherwise described herein may be understood to include one or more modules, fragments, or portions of code of an executable instruction to implement a particular logical function or process. In addition, the scope of at least one embodiment of the present disclosure includes additional implementations in which the functions may be performed in a sequence that is not shown or discussed, including in a substantially simultaneous manner or in the reverse order depending on the function involved, which is understood by those skilled in the art to which this present disclosure pertains.

Above are embodiments of the present disclosure, which does not limit the scope of the present disclosure. Any modifications, equivalent replacements or improvements within the spirit and principles of the embodiment described above should be covered by the protected scope of the disclosure.

**Claims**

1. A charging method for a terminal device, comprising:

   establishing a charging current mapping relationship according to a relationship between a charging information parameter and an open circuit voltage of a first electrode of a battery of the terminal device and a relationship between the charging information parameter and an impedance of the first electrode of the battery; wherein the charging current mapping relationship comprises a mapping relationship between the charging information parameter and a maximum battery charging current;
   obtaining the charging information parameter of the battery during a charging operation;
   determining a charging current according to the charging information parameter and the charging current mapping relationship; and
   charging the battery by using the charging current.

2. The charging method of claim 1, **characterized in that** before the step of establishing the charging current mapping relationship according to the relationship between the charging information parameter and the open circuit voltage of the first electrode of the battery of the terminal device and the relationship between the charging information parameter and the impedance of the first electrode of the battery, the charging method further comprises:

   obtaining a first relationship, comprising the relationship between the charging information parameter and the open circuit voltage of the first electrode of the battery of the terminal device; and
   obtaining a second relationship, comprising the relationship between the charging information parameter and the impedance of the first electrode of the battery.

3. The charging method of claim 2, **characterized in that** the charging information parameter comprises a battery power status, a battery temperature, and a battery cycle number, and the step of obtaining the first relationship comprises:

   obtaining a relationship between the open circuit voltage of the first electrode of the battery of the terminal device and at least one of the battery power status, the battery temperature, and the battery cycle number.

4. The charging method of claim 3, **characterized in that** the step of obtaining the second relationship comprises:

obtaining a relationship between the impedance of the first electrode of the battery and at least one of the battery power status, the battery temperature, and the battery cycle number.

5. The charging method of claim 4, **characterized in that** the step of obtaining the relationship between the impedance of the first electrode of the battery and at least one of the battery power status, the battery temperature, and the battery cycle number comprises:

utilizing a first current to charge or discharge the battery under a predetermined battery power status, a predetermined battery temperature, and a predetermined battery cycle to obtain a first voltage level of the first electrode; utilizing a second current to charge or discharge the battery under the predetermined battery power status, the predetermined battery temperature, and the predetermined battery cycle to obtain a second voltage level of the first electrode; and determining the impedance of the first electrode according to the first current, the first voltage level, the second current and the second voltage level.

6. The charging method of claim 1, **characterized in that** the step of charging the battery by using the charging current comprises:

determining whether a charging voltage reaches a cut-off voltage; and utilizing the charging current determined according to the charging current mapping relationship to charge the battery if the charging voltage does not reach the cut-off voltage.

7. The charging method of claim 6, **characterized in that** the charging method further comprises: utilizing the cut-off voltage to charge the battery if the charging voltage reaches the cut-off voltage.

8. The charging method of claim 1, **characterized in that** the step of charging the battery by using the charging current comprises:

determining whether a charging voltage reaches an over cut-off voltage; and utilizing the charging current determined according to the charging current mapping relationship to charge the battery if the charging voltage does not reach the over cut-off voltage.

9. The charging method of claim 8, **characterized in that** the charging method further comprises: utilizing the over cut-off voltage to charge the battery when the charging voltage reaches the cut-off voltage.

10. An electronic device comprising:

an establishing module, configured to establish a charging current mapping relationship according to a relationship between a charging information parameter and an open circuit voltage of a first electrode of a battery of the terminal device and a relationship between the charging information parameter and an impedance of the first electrode of the battery; wherein the charging current mapping relationship comprises a mapping relationship between the charging information parameter and a maximum battery charging current; a first obtaining module, configured to obtain the charging information parameter of the battery during a charging operation; a first determining module, configured to determine a charging current according to the charging information parameter and the charging current mapping relationship; and a charging module, configured to charge the battery by using the charging current.

11. The electronic device of claim 10, **characterized in that** the electronic device further comprises:

a second obtaining module, configured to obtain a first relationship comprising the relationship between the charging information parameter and the open circuit voltage of the first electrode of the battery of the terminal device; and a third obtaining module, configured to obtain a second relationship, comprising the relationship between the charging information parameter and the impedance of the first electrode of the battery.

12. The electronic device of claim 11, **characterized in that** the third obtaining module further comprises:

a first detecting sub-module, configured to obtain a first voltage level of the first electrode by utilizing a first current to charge or discharge the battery under a predetermined battery power status, a predetermined battery temperature, and a predetermined battery cycle; a second detecting sub-module, configured to obtain a second voltage level of the first electrode by utilizing a second current to charge or discharge the battery under the predetermined battery power status, the predetermined battery temperature, and the predetermined battery cycle; and a determining sub-module, configured to determine the impedance of the first electrode according to the first current, the first voltage level, the second current and the second voltage level.

13. The electronic device of claim 10, **characterized in that** the electronic device further comprises:

a first checking module, configured to determine whether a charging voltage reaches a cut-off voltage; and
a second determining module, configured to utilize the charging current determined according to the charging current mapping relationship to charge the battery if the charging voltage does not reach the cut-off voltage.

14. The electronic device of claim 13, **characterized in that** the electronic device further comprises:
a third determining module, configured to utilize the cut-off voltage to charge the battery if the charging voltage reaches the cut-off voltage.

15. The electronic device of claim 10, **characterized in that** the electronic device further comprises:

a second checking module, configured to determine whether a charging voltage reaches an over cut-off voltage; and
a fourth determining module, configured to utilize the charging current determined according to the charging current mapping relationship to charge the battery if the charging voltage does not reach the over cut-off voltage.

16. The electronic device of claim 15, **characterized in that** the electronic device further comprises:
a fifth determining module, configured to utilize the over cut-off voltage to charge the battery when the charging voltage reaches the cut-off voltage.

17. A charging system, used in a terminal device, the charging system comprising:

a checking circuit, configured to check a charging information parameter of a battery in the terminal device; and
a controller, connected to the checking circuit, configured to receive the charging information parameter, load a charging mapping relationship according to the charging information parameter, determine a charging current through the charging mapping relationship, and charge the battery by utilizing the charging current.

18. The charging system of claim 17, wherein the charging information parameter comprises a battery power status, a battery temperature and a power cycle number, the charging system comprising:

a temperature sensor, connected to the controller, configured to the battery temperature; a counter, connected to the controller, configured to record the battery cycle number; and
a power status detecting circuit, connected to the controller, configured to detect the battery power status.

19. An electronic device, comprising:

a processor; and
a storage device, configured to store computer readable instructions executable by the processor to perform the method as claimed in any one of claims 1-9.

20. A computer readable medium, storing computer readable programs for a processor to execute to perform the method as claimed in any one of claims 1-9.

Establish a charging current mapping relationship according to a relationship between a charging information parameter and an open circuit voltage of a first electrode of a battery of the terminal device and a relationship between the charging information parameter and an impedance of the first electrode of the battery, where the charging current mapping relationship comprises a mapping relationship between the charging information parameter and a maximum battery charging current. —S110

Obtain the charging information parameter of the battery during a charging operation. —S120

Determine a charging current according to the charging information parameter and the charging current mapping relationship. —S130

Charge the battery by using the charging current. —S140

Fig. 1

Obtain a first relationship comprising the relationship between the charging information parameter and the open circuit voltage of the first electrode of the battery of the terminal device. —S150

Obtain a second relationship comprising the relationship between the charging information parameter and the impedance of the first electrode of the battery. —S160

Fig. 2

Determine whether a charging voltage reaches a cut-off voltage. ⌐S141

Utilize the charging current determined according to the charging current mapping relationship to charge the battery when the charging voltage does not reach the cut-off voltage. ⌐S142

Fig. 3

Determine whether a charging voltage reaches a cut-off voltage. ⌐S141

Utilize the cut-off voltage to charge the battery when the charging voltage reaches the cut-off voltage. ⌐S170

Fig. 4

Determine whether a charging voltage reaches an over cut-off voltage. ⌐S143

Utilize the over cut-off voltage to charge the battery if the charging voltage does not reach the cut-off voltage. ⌐S144

Fig. 5

Determine whether a charging voltage reaches an over cut-off voltage. ⌐S143

Utilize the over cut-off voltage to charge the battery if the charging voltage reaches the cut-off voltage. ⌐S180

Fig. 6

| Establishing module 710 | First determining module 730 |
| First obtaining module 720 | Charging module 740 |

700

Fig. 7

700

| | |
|---|---|
| Second obtaining module 750 | First obtaining module 720 |
| Third obtaining module 760 | First determining module 730 |
| Establishing module 710 | Charging module 740 |

Fig. 8

760

| |
|---|
| First detecting sub-module 761 |
| Second detecting sub-module 762 |
| Determining sub-module 763 |

Fig. 9

700

| | | 740 |
| Establishing module (710) | | Charging module |
| First obtaining module (720) | | First checking module (770) |
| First determining module (730) | | Second determining module (780) |

Fig. 10

700

| | | 770 |
| Establishing module (710) | | First checking module |
| First obtaining module (720) | | Second determining module (780) |
| First determining module (730) | | Third determining module (790) |
| Charging module (740) | | |

Fig. 11

700

740

Establishing module 710

Charging module

First obtaining module 720

Second checking module 7110

First determining module 730

Fourth determining module 7120

Fig. 12

700

Establishing module 710

Second checking module 7110

First obtaining module 720

Fourth determining module 7120

First determining module 730

Fifth determining module 7130

Charging module 740

Fig. 13

810

811

Temperature sensor

812

Counter

813

Power status
checking circuit

820

Controller

830

Charging current
adjusting circuit

Fig. 14

900

920

Storage unit

9201

RAM

9203

ROM

910

9202

Cache

9204

9205

Processing
unit

930

940

950

Display

I/O
interface

960

Network adapter

970

External device

Fig. 15

1000

Program code

Fig. 16

## INTERNATIONAL SEARCH REPORT

| International application No. |
| --- |
| **PCT/CN2020/093513** |

**A.  CLASSIFICATION OF SUBJECT MATTER**

H02J 7/00(2006.01)i;  H01M 10/44(2006.01)i

According to International Patent Classification (IPC) or to both national classification and IPC

**B.  FIELDS SEARCHED**

Minimum documentation searched (classification system followed by classification symbols)

H02J;  H01M

Documentation searched other than minimum documentation to the extent that such documents are included in the fields searched

Electronic data base consulted during the international search (name of data base and, where practicable, search terms used)

CNABS, CNKI, DWPI, SIPOABS: 充电, 开路电压, 阻抗, 内阻, 电流, 映射, 关联, 对应关系, charging, open circuit voltage, impedance, internal resistance, current, mapping, relationship, correspondence

**C.  DOCUMENTS CONSIDERED TO BE RELEVANT**

| Category* | Citation of document, with indication, where appropriate, of the relevant passages | Relevant to claim No. |
| --- | --- | --- |
| PX | CN 110176795 A (GUANGDONG OPPO MOBILE TELECOMMUNICATIONS CORP., LTD.) 27 August 2019 (2019-08-27)<br>description, paragraphs 60-188, figures 1-10 | 1-20 |
| X | CN 105870525 A (NINGDE AMPEREX TECHNOLOGY LTD.) 17 August 2016 (2016-08-17)<br>description, paragraphs 71-153, figures 1-19 | 1-20 |
| X | CN 105846485 A (GUANGDONG MIDEA REFRIGERATION EQUIPMENT CO., LTD.) 10 August 2016 (2016-08-10)<br>description, paragraphs 30-65, figures 1-4 | 1-20 |
| X | CN 103022585 A (HYUNDAI MOTOR COMPANY et al.) 03 April 2013 (2013-04-03)<br>description, paragraphs [0021]-[0034], and figures 1-4 | 1-20 |
| A | US 2018097369 A1 (INTEL CORP) 05 April 2018 (2018-04-05)<br>entire document | 1-20 |

☐ Further documents are listed in the continuation of Box C.    ☑ See patent family annex.

| | |
| --- | --- |
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
| --- | --- |
| **12 August 2020** | **21 August 2020** |

| Name and mailing address of the ISA/CN | Authorized officer |
| --- | --- |
| **China National Intellectual Property Administration (ISA/CN)**<br>**No. 6, Xitucheng Road, Jimenqiao Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2020/093513**

| Patent document cited in search report | | | Publication date (day/month/year) | Patent family member(s) | | | Publication date (day/month/year) |
|---|---|---|---|---|---|---|---|
| CN | 110176795 | A | 27 August 2019 | None | | | |
| CN | 105870525 | A | 17 August 2016 | CN | 105870525 | B | 24 August 2018 |
| | | | | EP | 3261213 | A1 | 27 December 2017 |
| | | | | US | 2017366015 | A1 | 21 December 2017 |
| | | | | US | 10135279 | B2 | 20 November 2018 |
| CN | 105846485 | A | 10 August 2016 | None | | | |
| CN | 103022585 | A | 03 April 2013 | JP | 2013074785 | A | 22 April 2013 |
| | | | | US | 2013076313 | A1 | 28 March 2013 |
| | | | | DE | 102011089293 | A1 | 28 March 2013 |
| US | 2018097369 | A1 | 05 April 2018 | US | 10305292 | B2 | 28 May 2019 |
| | | | | WO | 2018063721 | A1 | 05 April 2018 |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201910463953